# EUROPÄISCHE PATENTSCHRIFT

(11) **EP 3 987 298 B1**
(45) Veröffentlichungstag und Bekanntmachung des Hinweises auf die Patenterteilung: **09.10.2024**
(21) Anmeldenummer: 20746879.4
(22) Anmeldetag: 10.07.2020
(51) Int. Cl.: G01R 15/16

(54) **MESSEN EINER ELEKTRISCHEN SPANNUNG AN EINEM METALLGEKAPSELTEN SCHALTGERÄT**
MEASURING AN ELECTRICAL VOLTAGE ON A METAL-ENCAPSULATED SWITCHGEAR
MESURE D'UNE TENSION ÉLECTRIQUE SUR UN APPAREILLAGE DE COMMUTATION À ENVELOPPE MÉTALLIQUE

(30) Priorität: 08.08.2019 DE 102019211950
(43) Veröffentlichungstag der Anmeldung: 27.04.2022
(73) Patentinhaber: Siemens Energy Global GmbH & Co. KG, 81739 München (DE)
(72) Erfinder: HILKER, Thomas, 14532 Stahnsdorf (DE); GIERE, Stefan, 14612 Falkensee (DE); HEINZ, Thomas, 14089 Berlin (DE)
(86) Internationale Anmeldenummer: PCT/EP2020/069487
(87) Internationale Veröffentlichungsnummer: WO 2021/023471

(56) Entgegenhaltungen:
- EP-A1- 1 261 091
- EP-A1- 2 689 256
- EP-A1- 2 990 811
- EP-A1- 3 276 363
- WO-A1-2014/082903
- WO-A1-2018/092188
- DE-A1- 19 855 528
- US-A- 3 988 684
- US-A1- 2011 148 393

## Beschreibung

Die Erfindung betrifft eine Messvorrichtung und ein Verfahren zum Messen einer elektrischen Spannung für ein metallgekapseltes Schaltgerät.

Unter einem metallgekapselten Schaltgerät wird ein Schaltgerät verstanden, das ein metallisches Gehäuse aufweist, welches in der Regel geerdet ist. Derartige Schaltgeräte sind beispielsweise Leistungsschalter und Trennschalter des so genannten Dead Tank Typs und/oder gasisoliert ausgeführte Schaltgeräte. In der Regel weist ein solches Schaltgerät einen Spannungswandler auf, um Spannungen des Schaltgeräts zu messen und zu überwachen. Insbesondere bei einem als ein Hochspannungsschalter ausgebildeten Schaltgerät wird die Spannung häufig über eine kapazitive Kopplung zwischen einer die Spannung führenden Primärleitung und einer Messelektrode gemäß dem Prinzip einer Feldsonde gemessen. Dazu wird die Messelektrode in unmittelbarer Nähe der Primärleitung angeordnet. Beispielsweise wird die Messelektrode in dem Gehäuse des Schaltgeräts angeordnet oder in einem zusätzlichen Flanschring, der um die Primärleitung herum verläuft. Aus der EP 3 276 363 A1 ist z. B. eine Messvorrichtung mit einem plattenförmigen Spannungssensor bekannt. EP 1 261 091 A1, EP 2 689 256 A1 und US 2011/148393 A1 offenbaren weitere relevante Beispiele für Messvorrichtungen aus dem Stand der Technik.

Der Erfindung liegt die Aufgabe zugrunde, eine verbesserte Messvorrichtung und ein verbessertes Verfahren zum Messen einer elektrischen Spannung für ein metallgekapseltes Schaltgerät anzugeben.

Die Aufgabe wird erfindungsgemäß durch eine Messvorrichtung mit den Merkmalen des Anspruchs 1, ein Verfahren mit den Merkmalen des Anspruchs 7 und ein Schaltgerät mit den Merkmalen des Anspruchs 8 gelöst.

Vorteilhafte Ausgestaltungen der Erfindung sind Gegenstand der Unteransprüche.

Eine erfindungsgemäße Messvorrichtung zum Messen einer elektrischen Spannung für ein metallgekapseltes Schaltgerät umfasst eine Elektroleitung, eine elektrisch leitfähige Messelektrode, die einen ersten Leitungsabschnitt der Elektroleitung umgibt und von der Elektroleitung elektrisch isoliert ist, und eine elektrisch leitfähige Feldsteuerelektrode, die von der Elektroleitung und der Messelektrode elektrisch isoliert ist und einen ersten Feldsteuerelektrodenabschnitt aufweist, der die Messelektrode umgibt.

Die Messelektrode und die Elektroleitung bilden einen Kondensator zur kapazitiven Erfassung einer elektrischen Spannung, die an der Elektroleitung gegenüber einem Bezugspotential liegt und über die eine an der Messelektrode gegenüber dem Bezugspotential liegende Spannung gemessen werden kann. Dabei ist die Messelektrode innerhalb der Feldsteuerelektrode angeordnet. Dadurch sind die Messelektrode und die Feldsteuerelektrode vorteilhaft platzsparend ausgeführt gegenüber einer Ausführung, in der die Messelektrode außerhalb der Feldsteuerelektrode angeordnet ist, weil bei einer Anordnung der Messelektrode außerhalb der Feldsteuerelektrode die Messelektrode und die Feldsteuerelektrode hintereinander entlang der Elektroleitung angeordnet werden müssten, da infolge der Abschirmwirkung der Feldsteuerelektrode eine Anordnung der Messelektrode beispielsweise um die Feldsteuerelektrode herum nicht möglich ist. Außerdem kann die Messelektrode innerhalb der Feldsteuerelektrode verbaut werden, ohne zusätzliche Bauteile für ihre Befestigung außerhalb der Feldsteuerelektrode zu benötigen.

Bei einer Ausgestaltung der Messvorrichtung weist die Feldsteuerelektrode einen zweiten Feldsteuerelektrodenabschnitt auf, der einen zweiten Leitungsabschnitt der Elektroleitung umgibt und einen kleineren maximalen Durchmesser in einer zu der Elektroleitung senkrechten Ebene als der erste Feldsteuerelektrodenabschnitt aufweist. Mit anderen Worten ist die Feldsteuerelektrode im Bereich des ersten Feldsteuerelektrodenabschnitts weiter als im zweiten Feldsteuerelektrodenabschnitt ausgeführt, um in dem ersten Feldsteuerelektrodenabschnitt vorteilhaft die Messelektrode aufnehmen zu können.

Bei einer weiteren Ausgestaltung der Messvorrichtung weist die Messelektrode ein U-förmiges Profil mit zwei von der Elektroleitung abgewandten Schenkeln auf. Die beiden Schenkel können insbesondere umgebogen ausgebildete Schenkelendbereiche aufweisen, um hohe elektrische Feldstärken zwischen den Schenkelendbereichen und der Feldsteuerelektrode zu vermeiden.

Bei einer weiteren Ausgestaltung der Messvorrichtung besteht die Feldsteuerelektrode aus Feldsteuerelektrodensegmenten, die entlang eines um die Elektroleitung verlaufenden Weges hintereinander angeordnet sind. Dadurch kann Material für die Fertigung der Feldsteuerelektrode eingespart werden. Ferner können beispielsweise Kabel zum Kontaktieren der Messelektrode zwischen den Feldsteuerelektrodensegmenten hindurch geführt sein.

Bei einer weiteren Ausgestaltung der Messvorrichtung besteht die Messelektrode aus Messelektrodensegmenten, die entlang eines um die Elektroleitung verlaufenden Weges hintereinander angeordnet sind. Dadurch kann Material für die Fertigung der Messelektrode eingespart werden. Ferner können beispielsweise an verschiedenen Messelektrodensegmenten liegende Messspannungen gemessen und zum Ermitteln der an der Elektroleitung liegenden Spannung gemittelt werden.

Die Messvorrichtung weist eine von der Feldsteuerelektrode umgebene Messspule auf, die von der Feldsteuerelektrode, der Elektroleitung und der Messelektrode elektrisch isoliert ist und um die Elektroleitung herum verläuft. Die Messspule ist als eine Rogowskispule ausgebildet. Eine Messspule ist beispielsweise zwischen der Messelektrode und der Feldsteuerelektrode angeordnet. Die Messelektrode und die Messspule sind entlang der Elektroleitung hintereinander angeordnet. Die Messspule ermöglicht, neben der an der Elektroleitung liegenden Spannung auch einen in der Elektroleitung fließenden Strom zu messen, indem eine in der Messspule induzierte Induktionsspannung gemessen wird. Die Anordnung der Messspule innerhalb der Feldsteuerelektrode ermöglicht vorteilhaft eine kompakte und platzsparende Ausführung der Messvorrichtung mit der Messspule.

Bei dem erfindungsgemäßen Verfahren zum Messen einer elektrischen Spannung, die an der Elektroleitung einer Messvorrichtung nach einem der vorhergehenden Ansprüche gegenüber einem Bezugspotential liegt, wird eine Messspannung gemessen, die an der Messelektrode der Messvorrichtung gegenüber dem Bezugspotential liegt, und aus der Messspannung wird die an der Elektroleitung der Messvorrichtung gegenüber dem Bezugspotential liegende Spannung ermittelt. Das erfindungsgemäße Verfahren nutzt aus, dass die an der Messelektrode liegende Messspannung proportional zu der an der Elektroleitung liegenden Spannung (jeweils gegenüber dem Bezugspotential) ist.

Ein erfindungsgemäßes metallgekapseltes Schaltgerät zum Unterbrechen und Schließen eines elektrischen Strompfads, beispielsweise ein Leistungsschalter oder ein Trennschalter, weist eine erfindungsgemäße Messvorrichtung auf, wobei der Strompfad durch die Elektroleitung der Messvorrichtung führt. Die Vorteile eines erfindungsgemäßen Schaltgeräts ergeben sich aus den oben genannten Vorteilen einer erfindungsgemäßen Messvorrichtung.

Eine Ausgestaltung eines erfindungsgemäßen Schaltgeräts sieht vor, dass die Feldsteuerelektrode der Messvorrichtung auf ein Erdpotential gelegt ist. Dadurch wird vorteilhaft vermieden, dass die Feldsteuerelektrode ein unerwünschtes elektrisches Potential annimmt.

Eine Ausgestaltung eines erfindungsgemäßen Schaltgeräts weist ein metallisches Gehäuse und eine Durchführung in das Gehäuse auf, wobei die Elektroleitung der Messvorrichtung durch die Durchführung verläuft und die Feldsteuerelektrode in der Durchführung angeordnet ist. Die Anordnung der Feldsteuerelektrode und damit auch der Messelektrode in einer Durchführung in das Gehäuse des Schaltgeräts hat gegenüber einer Anordnung in dem Gehäuse den Vorteil, dass das Gehäuse keinen Bauraum für die Feldsteuerelektrode aufweisen muss und dadurch kompakter ausgeführt werden kann.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Schnittdarstellung eines Ausführungsbeispiels eines Schaltgeräts,
- FIG 2: eine Schnittdarstellung eines ersten Ausführungsbeispiels einer Messvorrichtung zum Messen einer elektrischen Spannung,
- FIG 3: eine Schnittdarstellung eines zweiten Ausführungsbeispiels einer Messvorrichtung zum Messen einer elektrischen Spannung,
- FIG 4: eine Schnittdarstellung eines dritten Ausführungsbeispiels einer Messvorrichtung zum Messen einer elektrischen Spannung,
- FIG 5: eine Schnittdarstellung eines vierten Ausführungsbeispiels einer Messvorrichtung zum Messen einer elektrischen Spannung.

Einander entsprechende Teile sind in den Figuren mit den gleichen Bezugszeichen versehen.

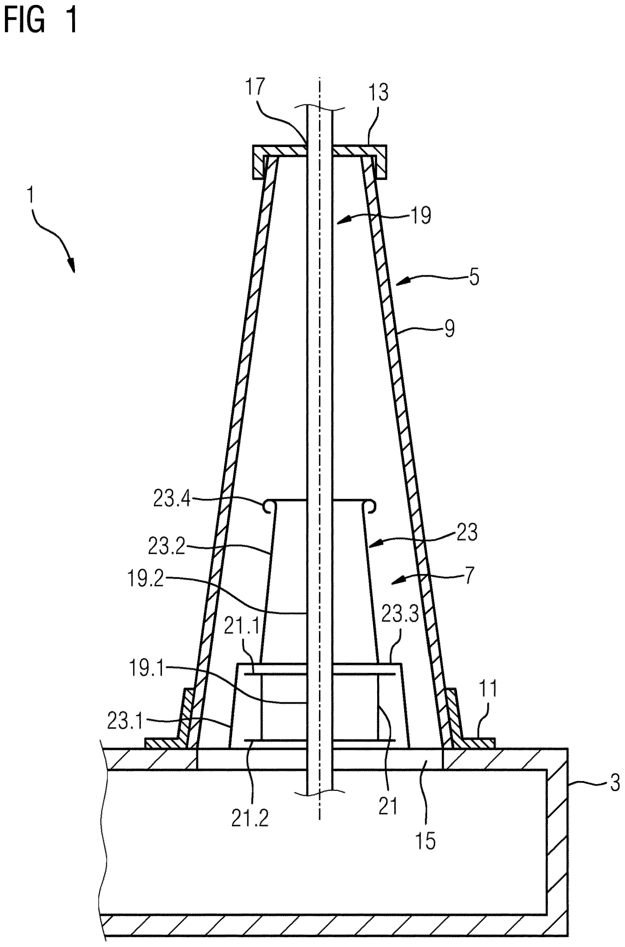

Figur 1 (FIG 1) zeigt eine Schnittdarstellung eines Ausführungsbeispiels eines erfindungsgemäßen metallgekapselten Schaltgeräts 1 zum Unterbrechen und Schließen eines elektrischen Strompfads. Das Schaltgerät 1 ist beispielsweise ein Leistungsschalter oder ein Trennschalter. Das Schaltgerät 1 weist ein metallisches Gehäuse 3, eine Durchführung 5 in das Gehäuse 3 und ein erstes Ausführungsbeispiel einer Messvorrichtung 7 zum Messen einer elektrischen Spannung auf. Das Schaltgerät 1 ist nur im Bereich der Durchführung 5 dargestellt, da nur dieser Bereich erfindungsrelevant ist.

Die Durchführung 5 weist einen trichterförmigen Isolator 9, einen Flansch 11 und einen Deckel 13 auf. Der Isolator 9 ist aus einem elektrisch isolierenden Material gefertigt, erstreckt sich von einer Gehäuseöffnung 15 des Gehäuses 3 weg, weist eine kegelstumpfförmige Außenoberfläche auf und verengt sich zunehmend mit zunehmendem Abstand von der Gehäuseöffnung 15. Der Flansch 11 verläuft an dem Gehäuse 3 ringförmig um ein gehäuseseitiges Ende des Isolators 9 herum und fixiert den Isolator 9 an dem Gehäuse 3. Der Deckel 13 verschließt ein von dem Gehäuse 3 abgewandtes Ende des Isolators 9 bis auf eine Deckelöffnung 17.

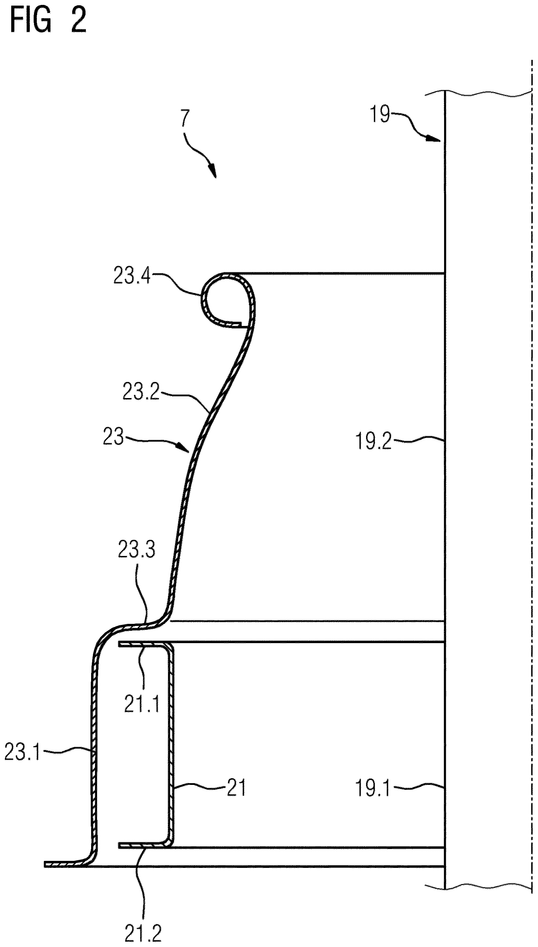

Figur 2 (FIG 2) zeigt eine vergrößerte Schnittdarstellung der Messvorrichtung 7 des in Figur 1 dargestellten Schaltgeräts 1. Die Messvorrichtung 7 umfasst eine Elektroleitung 19, eine elektrisch leitfähige Messelektrode 21 und eine elektrisch leitfähige Feldsteuerelektrode 23. Die Elektroleitung 19, die Messelektrode 21 und die Feldsteuerelektrode 23 sind voneinander elektrisch isoliert.

Die Elektroleitung 19 verläuft durch die Deckelöffnung 17 in die Durchführung 5 und durch die Durchführung 5 in das Gehäuse 3 hinein und ist Teil des Strompfads, der von dem Schaltgerät 1 unterbrochen und geschlossen wird.

Die Messelektrode 21 umgibt ringartig einen ersten Leitungsabschnitt 19.1 der Elektroleitung 19. Die Messelektrode 21 weist ein U-förmiges Profil mit zwei von der Elektroleitung 19 abgewandten Schenkeln 21.1, 21.2 auf.

Die Feldsteuerelektrode 23 ist trichterförmig ausgeführt. Ein erster Feldsteuerelektrodenabschnitt 23.1 der Feldsteuerelektrode 23 umgibt die Messelektrode 21. Ein zweiter Feldsteuerelektrodenabschnitt 23.2 der Feldsteuerelektrode 23 umgibt einen zweiten Leitungsabschnitt 19.2 der Elektroleitung 19, der sich an den ersten Leitungsabschnitt 19.1 anschließt. Zwischen dem ersten Feldsteuerelektrodenabschnitt 23.1 und dem zweiten Feldsteuerelektrodenabschnitt 23.2 weist die Feldsteuerelektrode 23 einen stufenartigen Übergangsbereich 23.3 auf, in dem ihr Durchmesser in einer zu der Elektroleitung 19 senkrechten Ebene von dem ersten Feldsteuerelektrodenabschnitt 23.1 zu dem zweiten Feldsteuerelektrodenabschnitt 23.2 abnimmt. Der zweite Feldsteuerelektrodenabschnitt 23.2 verengt sich zunehmend mit zunehmendem Abstand von dem ersten Feldsteuerelektrodenabschnitt 23.1 bis zu einem Endbereich 23.4 der Feldsteuerelektrode 23, der von der Elektroleitung 19 weg umgebogen ausgebildet ist.

Im Betrieb des Schaltgeräts 1 werden die Feldsteuerelektrode 23 und das Gehäuse 3 auf ein Erdpotential gelegt. Die Messelektrode 21 und die Elektroleitung 19 bilden einen Zylinderkondensator, mit dem kapazitiv eine elektrische Spannung gemessen wird, die an der Elektroleitung 19 gegenüber einem Bezugspotential liegt. Dazu wird eine Messspannung gemessen, die an der Messelektrode 21 gegenüber dem Bezugspotential liegt, und aus der Messspannung wird die an der Elektroleitung 19 gegenüber dem Bezugspotential liegende Spannung ermittelt. Die Messspannung wird beispielsweise an einem mit der Messelektrode 21 elektrisch verbundenen (nicht dargestellten) Kabel abgegriffen, das elektrisch isoliert durch die Feldsteuerelektrode 23 hindurch oder aus der Feldsteuerelektrode 23 heraus geführt ist.

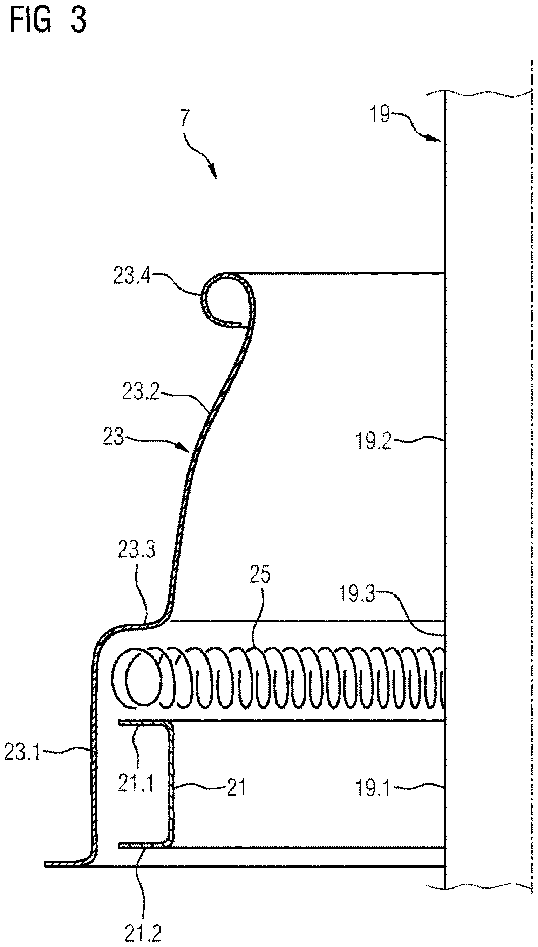

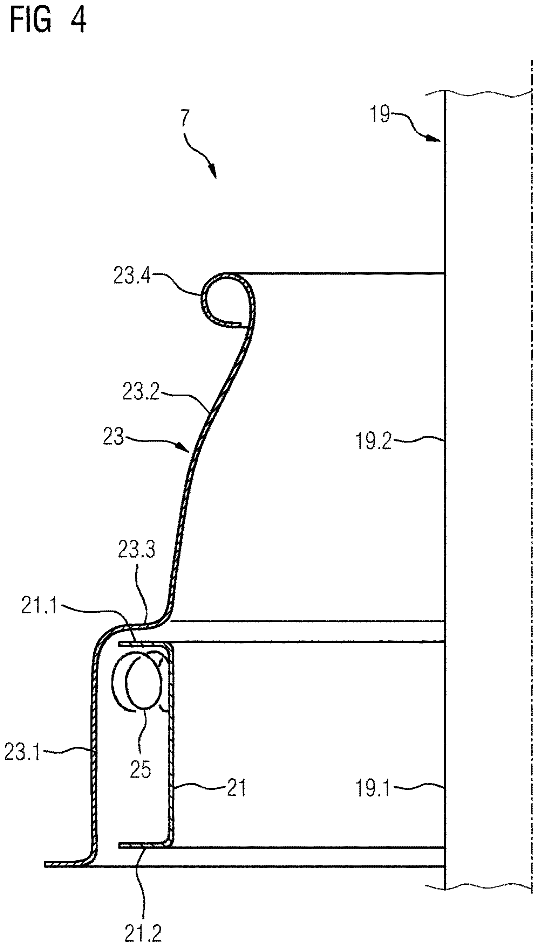

Das in Figur 1 gezeigte Ausführungsbeispiel eines Schaltgeräts 1 kann in verschiedener Weise abgewandelt werden. Insbesondere kann das Schaltgerät 1 statt der in Figur 2 gezeigten Messvorrichtung 7 eine unten in Figur 3 oder Figur 4 gezeigte Messvorrichtung 7 aufweisen. Ferner können die Messelektrode 21 und die Feldsteuerelektrode 23 in dem Gehäuse 3 statt in der Durchführung 5 angeordnet sein.

Figur 3 (FIG 3) zeigt eine Schnittdarstellung eines zweiten Ausführungsbeispiels einer erfindungsgemäßen Messvorrichtung 7. Dieses Ausführungsbeispiel unterscheidet sich von dem in den Figuren 1 und 2 gezeigten Ausführungsbeispiel im Wesentlichen dadurch, dass es neben der Elektroleitung 19, der Messelektrode 21 und der Feldsteuerelektrode 23 eine Messspule 25 aufweist, die ringförmig um einen dritten Leitungsabschnitt 19.3 zwischen dem ersten Leitungsabschnitt 19.1 und dem zweiten Leitungsabschnitt 19.2 der Elektroleitung 19 herum verläuft und zusammen mit der Messelektrode 21 von dem ersten Feldsteuerelektrodenabschnitt 23.1 umgeben ist. Die Messspule 25 ist als eine Rogowskispule ausgebildet und von der Elektroleitung 19, der Messelektrode 21 und der Feldsteuerelektrode 23 elektrisch isoliert. Mit der Messspule 25 wird ein elektrischer Strom gemessen, der in der Elektroleitung 19 fließt. Dazu wird eine in der Messspule 25 induzierte Induktionsspannung gemessen und aus der Induktionsspannung der in der Elektroleitung 19 fließende Strom ermittelt. Beispielsweise wird die Induktionsspannung zwischen mit der Messelektrode 21 elektrisch verbundenen (nicht dargestellten) Kabeln abgegriffen, die elektrisch isoliert durch die Feldsteuerelektrode 23 hindurch oder aus der Feldsteuerelektrode 23 heraus geführt sind.

Figur 4 (FIG 4) zeigt eine Schnittdarstellung eines dritten Ausführungsbeispiels einer erfindungsgemäßen Messvorrichtung 7. Dieses Ausführungsbeispiel unterscheidet sich von dem in Figur 3 gezeigten Ausführungsbeispiel im Wesentlichen dadurch, dass die Messspule 25 zwischen der Messelektrode 21 und der Feldsteuerelektrode 23 und den beiden Schenkeln 21.1 und 21.2 der Messelektrode 21 angeordnet ist.

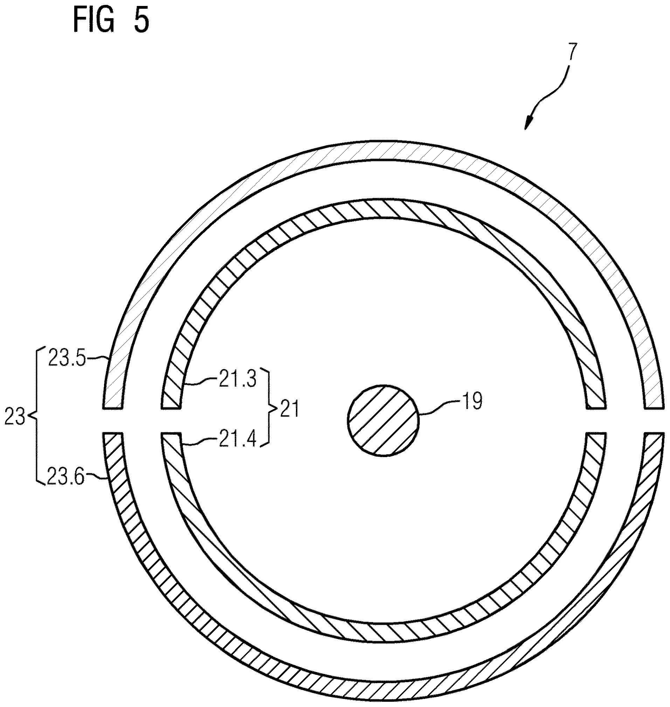

Figur 5 (FIG 5) zeigt ein viertes Ausführungsbeispiel einer erfindungsgemäßen Messvorrichtung 7 in einer Schnittdarstellung mit einer zu der Elektroleitung 19 senkrechten Schnittebene. Bei diesem Ausführungsbeispiel besteht die Feldsteuerelektrode 23 aus zwei entlang eines um die Elektroleitung 19 verlaufenden Weges hintereinander und voneinander beabstandet angeordneten Feldsteuerelektrodensegmenten 23.5, 23.6 und die Messelektrode 21 besteht aus zwei entlang eines um die Elektroleitung 19 verlaufenden Weges hintereinander und voneinander beabstandet angeordneten Messelektrodensegmenten 21.3, 21.4. Abgesehen von der segmentierten Ausführung der Feldsteuerelektrode 23 und der Messelektrode 21 kann die Messvorrichtung 7 wie in einer der Figuren 2 bis 4 ausgebildet sein.

Die in den Figuren 2 bis 5 gezeigten Ausführungsbeispiele von Messvorrichtungen 7 können in verschiedener Art und Weise weitergestaltet werden. Beispielsweise kann die Messelektrode 21 ganz oder teilweise in eine Gussmasse, beispielsweise in Epoxidharz, eingegossen sein und durch die Gussmasse mit der Feldsteuerelektrode 23 verbunden sein, ohne jedoch elektrisch mit der Feldsteuerelektrode 23 verbunden zu sein. Ferner kann bei den in den Figuren 3 und 4 gezeigten Ausführungsbeispielen die Messspule 25 ganz oder teilweise in eine Gussmasse, beispielsweise in Epoxidharz, eingegossen sein und durch die Gussmasse mit der Feldsteuerelektrode 23 und/oder der Messelektrode 21 verbunden sein, ohne jedoch elektrisch mit der Feldsteuerelektrode 23 oder der Messelektrode 21 verbunden zu sein. Ferner kann die Messelektrode 21 beispielsweise als eine elektrisch leitfähige Folie ausgebildet sein. Des Weiteren können die Feldsteuerelektrode 23 und/oder die Messelektrode 21 fensterartige Öffnungen aufweisen. Das in Figur 5 gezeigte Ausführungsbeispiel kann beispielsweise dahin gehend abgewandelt werden, dass die Feldsteuerelektrode 23 mehr als zwei Feldsteuerelektrodensegmente 23.5, 23.6 aufweist und/oder die Messelektrode 21 mehr als zwei Messelektrodensegmente 21.3, 21.4 aufweist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Messvorrichtung (7) zum Messen einer elektrischen Spannung für ein metallgekapseltes Schaltgerät (1), die Messvorrichtung (7) umfassend
- eine Elektroleitung (19),
- eine elektrisch leitfähige Messelektrode (21), die einen ersten Leitungsabschnitt (19.1) der Elektroleitung (19) umgibt und von der Elektroleitung (19) elektrisch isoliert ist, und
- eine elektrisch leitfähige Feldsteuerelektrode (23), die von der Elektroleitung (19) und der Messelektrode (21) elektrisch isoliert ist,
- wobei die Feldsteuerelektrode (23) einen ersten Feldsteuerelektrodenabschnitt (23.1) aufweist, der die Messelektrode (21) umgibt, und
- mit einer von der Feldsteuerelektrode (23) umgebenen Messspule (25) zur Strommessung, wobei die Messspule (25) von der Feldsteuerelektrode (23), der Elektroleitung (19) und der Messelektrode (21) elektrisch isoliert ist und um die Elektroleitung (19) herum verläuft, wobei die Messspule (25) als eine Rogowskispule ausgebildet ist,
**dadurch gekennzeichnet, dass** die Messelektrode (21) und die Messspule (25) entlang der Elektroleitung (19) hintereinander angeordnet sind.

2. Messvorrichtung (7) nach Anspruch 1, wobei die Feldsteuerelektrode (23) einen zweiten Feldsteuerelektrodenabschnitt (23.2) aufweist, der einen zweiten Leitungsabschnitt (19.2) der Elektroleitung (19) umgibt und einen kleineren maximalen Durchmesser in einer zu der Elektroleitung (19) senkrechten Ebene als der erste Feldsteuerelektrodenabschnitt (23.1) aufweist.

3. Messvorrichtung (7) nach Anspruch 1 oder 2, wobei die Messelektrode (21) ein U-förmiges Profil mit zwei von der Elektroleitung (19) abgewandten Schenkeln (21.1, 21.2) aufweist.

4. Messvorrichtung (7) nach einem der vorhergehenden Ansprüche, wobei die Feldsteuerelektrode (23) aus Feldsteuerelektrodensegmenten (23.5, 23.6) besteht, die entlang eines um die Elektroleitung (19) verlaufenden Weges hintereinander angeordnet sind.

5. Messvorrichtung (7) nach einem der vorhergehenden Ansprüche, wobei die Messelektrode (21) aus Messelektrodensegmenten (21.3, 21.4) besteht, die entlang eines um die Elektroleitung (19) verlaufenden Weges hintereinander angeordnet sind.

6. Messvorrichtung (7) nach einem der vorhergehenden Ansprüche, wobei die Messspule (25) zwischen der Messelektrode (21) und der Feldsteuerelektrode (23) angeordnet ist.

7. Verfahren zum Messen einer elektrischen Spannung, die an der Elektroleitung (19) einer Messvorrichtung (7) nach einem der vorhergehenden Ansprüche gegenüber einem Bezugspotential liegt, wobei eine Messspannung gemessen wird, die an der Messelektrode (21) der Messvorrichtung (7) gegenüber dem Bezugspotential liegt, und aus der Messspannung die an der Elektroleitung (19) der Messvorrichtung (7) gegenüber dem Bezugspotential liegende Spannung ermittelt wird.

8. Metallgekapseltes Schaltgerät (1) zum Unterbrechen und Schließen eines elektrischen Strompfads, das eine Messvorrichtung (7) nach einem der Ansprüche 1 bis 6 aufweist, wobei der Strompfad durch die Elektroleitung (19) der Messvorrichtung (7) führt.

9. Schaltgerät (1) nach Anspruch 8, wobei die Feldsteuerelektrode (23) der Messvorrichtung (7) auf ein Erdpotential gelegt ist.

10. Schaltgerät (1) nach Anspruch 8 oder 9 mit einem metallischen Gehäuse (3) und einer Durchführung (5) in das Gehäuse (3), wobei die Elektroleitung (19) der Messvorrichtung (7) durch die Durchführung (5) verläuft und die Feldsteuerelektrode (23) in der Durchführung (5) angeordnet ist.

11. Schaltgerät (1) nach einem der Ansprüche 8 bis 10, das ein Leistungsschalter oder ein Trennschalter ist.

## Claims

1. Measuring apparatus (7) for measuring an electrical voltage for a metal-encapsulated switchgear (1), the measuring apparatus (7) comprising
- an electrical line (19),
- an electrically conductive measuring electrode (21) that surrounds a first line portion (19.1) of the electrical line (19) and is electrically insulated from the electrical line (19), and
- an electrically conductive field control electrode (23) that is electrically insulated from the electrical line (19) and the measuring electrode (21),
- wherein the field control electrode (23) comprises a first field control electrode portion (23.1) that surrounds the measuring electrode (21), and
- with a measuring coil (25) for current measurement surrounded by the field control electrode (23), wherein the measuring coil (25) is electrically insulated from the field control electrode (23), the electrical line (19) and the measuring electrode (21), and extends around the electrical line (19), wherein the measuring coil (25) is designed as a Rogowski coil,
**characterized in that** the measuring electrode (21) and the measuring coil (25) are arranged one after another along the electrical line (19).

2. Measuring apparatus (7) according to Claim 1, wherein the field control electrode (23) comprises a second field control electrode portion (23.2) that surrounds a second line portion (19.2) of the electrical line (19) and has a smaller maximum diameter in a plane perpendicular to the electrical line (19) than the first field control electrode portion (23.1).

3. Measuring apparatus (7) according to Claim 1 or 2, wherein the measuring electrode (21) has a U-shaped profile with two legs (21.1, 21.2) that face away from the electrical line (19).

4. Measuring apparatus (7) according to one of the preceding claims, wherein the field control electrode (23) consists of field control electrode segments (23.5, 23.6) that are arranged one after another along a path extending around the electrical line (19).

5. Measuring apparatus (7) according to one of the preceding claims, wherein the measuring electrode (21) consists of measuring electrode segments (21.3, 21.4) that are arranged one after another along a path extending around the electrical line (19) .

6. Measuring apparatus (7) according to one of the preceding claims, wherein the measuring coil (25) is arranged between the measuring electrode (21) and the field control electrode (23).

7. Method for measuring an electrical voltage that is present at the electrical line (19) of a measuring apparatus (7) according to one of the preceding claims with respect to a reference potential, wherein a measurement voltage is measured that is present at the measuring electrode (21) of the measuring apparatus (7) with respect to the reference potential, and the voltage present at the electrical line (19) of the measuring apparatus (7) with respect to the reference potential is ascertained from the measurement voltage.

8. Metal-encapsulated switchgear (1) for interrupting and closing an electrical current path that comprises a measuring apparatus (7) according to one of Claims 1 to 6, wherein the current path passes through the electrical line (19) of the measuring apparatus (7).

9. Switchgear (1) according to Claim 8, wherein the field control electrode (23) of the measuring apparatus (7) is placed at a ground potential.

10. Switchgear (1) according to Claim 8 or 9 with a metal housing (3) and a bushing (5) in the housing (3), wherein the electrical line (19) of the measuring apparatus (7) extends through the bushing (5), and the field control electrode (23) is arranged in the bushing (5).

11. Switchgear (1) according to one of Claims 8 to 10 that is a power switch or a circuit breaker.

## Revendications

1. Dispositif (7) de mesure d'une tension électrique pour un appareil (1) de coupure à blindage métallique, le dispositif (7) de mesure comprenant
- une ligne (19) électrique,
- une électrode (21) de mesure conductrice de l'électricité, qui entoure un premier tronçon (19.1) de la ligne (19) électrique et qui est isolée électriquement de la ligne (19) électrique, et
- une électrode (23) de commande de champ, conductrice de l'électricité, qui est isolée électriquement de la ligne (19) électrique et de l'électrode (21) de mesure,
- dans lequel l'électrode (23) de commande de champ a une première partie (23.1) d'électrode de commande de champ, qui entoure l'électrode (21) de mesure, et
- comprenant, pour la mesure du courant, une bobine (25) de mesure entourée de l'électrode (23) de commande de champ, dans lequel la bobine (25) de mesure est isolée électriquement de l'électrode (23) de commande de champ, de la ligne (19) électrique et de l'électrode (21) de mesure et s'étend autour de la ligne (19) électrique, la bobine (25) de mesure étant constituée en bobine de Rogowski,
- **caractérisé en ce que** l'électrode (21) de mesure et la bobine (25) de mesure sont disposées l'une derrière l'autre le long de la ligne (19) électrique.

2. Dispositif (7) de mesure suivant la revendication 1, dans lequel l'électrode (23) de commande de champ a une deuxième partie (23.2) d'électrode de commande de champ, qui entoure un deuxième tronçon (19.2) de la ligne (19) électrique et a un diamètre maximum plus petit, dans un plan perpendiculaire à la ligne (19) électrique, que la première partie (23.1) d'électrode de commande de champ.

3. Dispositif (7) suivant la revendication 1 ou 2, dans lequel l'électrode (21) de mesure a un profil en forme de U ayant deux branches (21.1, 21.2) non tournées vers la ligne (19) d'électrode.

4. Dispositif (7) suivant l'une des revendications précédentes, dans lequel l'électrode (23) de commande de champ est constituée de segments (23.5, 23.6) d'électrode de commande de champ, qui sont disposés les uns derrière les autres le long d'un chemin s'étendant autour de la ligne (19) électrique.

5. Dispositif (7) suivant l'une des revendications précédentes, dans lequel l'électrode (21) de mesure est constituée de segments (21.3, 21.4) d'électrode de mesure, qui sont disposés les uns derrière les autres le long d'un chemin s'étendant autour de la ligne (19) électrique.

6. Dispositif (7) suivant l'une des revendications précédentes, dans lequel la bobine (25) de mesure est interposée entre l'électrode (21) de mesure et l'électrode (23) de commande de champ.

7. Procédé de mesure d'une tension électrique, qui s'applique à la ligne (19) électrique d'un dispositif (7) de mesure suivant l'une des revendications précédentes, par rapport à un potentiel de référence, dans lequel on mesure une tension de mesure, qui s'applique à l'électrode (21) de la mesure du dispositif (7) de mesure par rapport au potentiel de référence, et à partir de la tension de mesure, on détermine la tension s'appliquant à la ligne (19) électrique du dispositif (7) de mesure par rapport au potentiel de référence.

8. Appareil (1) de coupure à blindage métallique pour l'interruption et la fermeture d'un chemin de courant électrique, qui a un dispositif (7) de mesure suivant l'une des revendications 1 à 6, dans lequel le chemin de courant passe par la ligne (19) électrique du dispositif (7) de mesure.

9. Appareil (1) de coupure suivant la revendication 8, dans lequel l'électrode (23) de commande de champ du dispositif (7) de mesure est mise à un potentiel de terre.

10. Appareil (1) de coupure suivant la revendication 8 ou 9, comprenant un boîtier (3) métallique et une traversée (5) dans le boîtier (3), dans lequel la ligne (19) électrique du dispositif (7) de mesure passe dans la traversée (5) et l'électrode (23) de commande de champ est disposée dans la traversée (5).

11. Appareil (1) de coupure suivant l'une des revendications 8 à 10, qui est un disjoncteur ou un sectionneur.
